Europäisches Patentamt

European Patent Office

Office européen des brevets

(11) Veröffentlichungsnummer: **0 226 126**
**A2**

(12) **EUROPÄISCHE PATENTANMELDUNG**

(21) Anmeldenummer: 86116792.2

(22) Anmeldetag: 03.12.86

(51) Int. Cl.⁴: **B65H 49/00** , H05K 13/06

(30) Priorität: 09.12.85 DE 3543477

(43) Veröffentlichungstag der Anmeldung:
24.06.87 Patentblatt 87/26

(84) Benannte Vertragsstaaten:
AT BE CH DE FR GB IT LI LU NL SE

(71) Anmelder: Siemens Aktiengesellschaft Berlin
und München
Wittelsbacherplatz 2
D-8000 München 2(DE)

(72) Erfinder: Eidling, Karl
Riedhofweg 3
D-8195 Egling(DE)

(54) **Drahtabziehvorrichtung.**

(57) Für das automatische Legen von -
schmelzkleberummantelten Feindrähten auf Baugruppenleiterplatten ist es erforderlich, daß beim
Verlegevorgang der Draht annähernd reibungs-und
trägheitsfrei aus einer Vorratsschlaufe abgezogen
werden kann. Hierzu ist gemäß der Erfindung im Anschluß an eine Drahtvorratsspule eine mit Druckluft
beaufschlagte Schlaufenkammer mit einer Tasteinrichtung vorgesehen, die den Luftstrom nach Erreichen einer bestimmten Schlaufengröße abschaltet.

FIG 1

EP 0 226 126 A2

## Drahtabziehvorrichtung.

Die Erfindung betrifft eine Drahtabziehvorrichtung zur Bereitstellung von Feindrähten, insbesondere für automatische Verlegeeinrichtungen.

Für das automatische Legen von schmelzkleberummantelten Feindrähten (ca. 80 µm) auf Baugruppen ist es erforderlich, daß beim Verlegevorgang der Draht annähernd reibungs-und trägheitsfrei aus einer Vorratsschlaufe abgezogen werden kann.

Die für Spulenwickelmaschinen üblichen Drahtabziehvorrichtungen bestehen meist aus einer Vielzahl von bewegten Teilen, die bei schnellen Veränderungen der Abziehgeschwindigkeit starke Schwankungen der Abziehkraft verursachen. Außerdem muß die Kraft für das Abziehen des Drahtes von der Vorratsspule bei bekannten Vorrichtungen durch den Wickel-bzw. Verlegevorgang aufgebracht werden. Das Abziehen des Drahtes über Kopf wird durch die Klebeneigung des Drahtes erschwert.

Der Erfindung liegt die Aufgabe zugrunde, eine Drahtabziehvorrichtung gemäß dem Oberbegriff des Anspruchs 1 zu konzipieren. Dabei soll in Verlegepausen die Vorratsschlaufe neu gebildet und gleichzeitig der Draht von der Spule abgezogen werden. Schnelle Lageänderungen der Drahtabziehvorrichtung dürfen zu keiner Verdrillung bzw. Knotenbildung führen.

Diese Aufgabe wird dadurch gelöst, daß im Anschluß an eine Drahtvorratsspule eine mit Druckluft beaufschlagte Schlaufenkammer mit einer Tastvorrichtung vorgesehen ist, die den Luftstrom nach Erreichen einer bestimmten Schlaufengröße abschaltet.

Weitere Einzelheiten der Erfindung sind Gegenstand der Unteransprüche.

Vorteile dieser Drahtbereitstellung sind:

1. Kompakter Aufbau.

2. Weitgehend reibungs-und trägheitsarmes Abziehen des Drahtes aus der Vorratsschlaufe.

3. Die Drahtvorratsschlaufe kann lageunabhängig, beschleunigungsunempfindlich und ohne die Gefahr von Knotenbildung bzw. Verdrillung gebildet und bereitgehalten werden.

4. Die bei der Schlaufenbildung entstehende Zugkraft reicht aus, um den Draht von der Spule zu ziehen.

5. Die Lage der Drahtvorratsschlaufe kann ohne mechanische Übertragungsteile direkt abgefragt werden.

Die Erfindung wird anhand · der Figuren erläutert. Es zeigen:

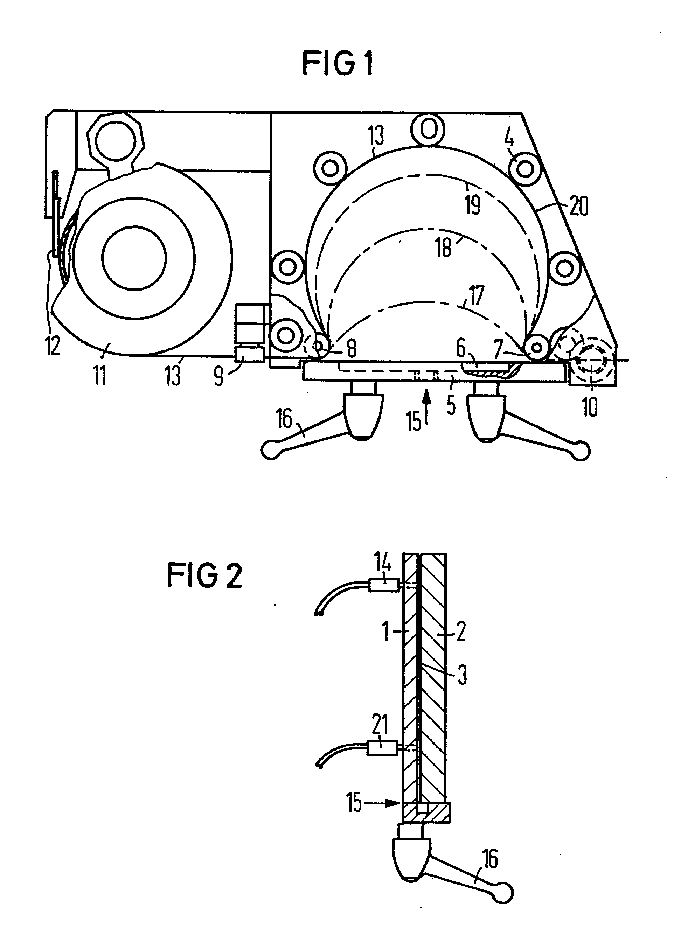

Figur 1 eine Drahtvorratsspule mit einer geöffneten Schlaufenkammer in der Vorderansicht und

Figur 2 diese Einrichtung in der Seitenansicht.

Eine Grundplatte 1 und eine vorzugsweise aus Glas bestehende Deckplatte 2 bilden die Seitenwände einer Schlaufenkammer 3, in der Abstandshalter 4 angeordnet sind. Nach unten ist die Schlaufenkammer durch eine Verschlußplatte 5, in der sich Luftverteiler 6 befindet, abgeschlossen. Mit 7 -9 sind Umlenkrollen bezeichnet. An der Verlegeseite befindet sich zum Klemmen des Drahtes ein Klemmbacken 10.

Eine Vorratsspule 11 weist eine Nachlaufbremse 12 für den Draht 13 auf. Ein Reflextaster mit Glasfaseroptik hat das Bezugszeichen 14 und der Druckluftanschluß das Bezugszeichen 15. Zum Einlegen des Drahtes kann die Verschlußplatte 5 mit den Hebeln 16 geöffnet werden. 17 -19 charakterisieren das Anwachsen der Schlaufe bis zur maximalen Größe 20.

Die Funktionen laufen folgendermaßen ab: Nach Erreichen einer vorgegebenen Verlegelänge oder nach Ansprechen des als Minimumabfrage dienenden Reflextasters 21 wird in Verlegepausen die Vorratsschlaufe neu gebildet. Dabei wird die aus den Platten 1 und 2 und den Abstandshaltern 4 gebildete Schlaufenkammer 3 über den Luftverteiler 6 in der Verschlußplatte 5 mit Druckluft beaufschlagt. Der Draht 13 wird dabei durch die Luftströmung schlaufenförmig 17 -20 in die durch die Abstandshalter 4 auf den Drahtdurchmesser abgestimmte Kammer geschoben.

Nach Erreichen einer bestimmten Schlaufengröße 20 wird der Luftstrom über den Reflextaster 14 mit Glasfaseroptik abgeschaltet.

Da der Draht verlegeseitig mit einem pneumatisch betätigten Klemmbacken 10 geklemmt ist, wird durch die Schlaufenbildung der Draht über die Umlenkrollen 8 und 9 von der Vorratsspule 11 mit Nachlaufbremse 12, vorzugsweise einer pneumatischen Bremse, abgewickelt.

Nach Lösen der Klemmung 10 kann der Draht 13 aus der Schlaufenkammer 3 über die Umlenkrolle 7 abgezogen werden.

Bezugszeichenliste

1 Grundplatte
2 Deckplatte
3 Schlaufenkammer
4 Abstandshalter
5 Verschlußplatte
6 Luftverteiler
7 Umlenkrolle
8 Umlenkrolle

9 Umlenkrolle
10 Klemmbacken
11 Vorratsspule
12 Nachlaufbremse
13 Draht
14 Reflextaster
15 Druckluftanschluß
16 Hebel
17 verschiedene Schlaufengrößen
18 verschiedene Schlaufengrößen
19 verschiedene Schlaufengrößen
20 maximale Schlaufengröße

## Ansprüche

1. Drahtabziehvorrichtung zur Bereitstellung von Feindrähten, insbesondere für automatische Verlegeeinrichtungen, **dadurch gekennzeichnet**, daß im Anschluß an eine Drahtvorratsspule (11) mit Nachlaufbremse (12) eine mit Druckluft beaufschlagte Schlaufenkammer (3) mit einer Tastvorrichtung (14) vorgesehen ist, die den Luftstrom nach Erreichen einer bestimmten Schlaufengröße - (20) abschaltet.

2. Drahtabziehvorrichtung nach Anspruch 1, **dadurch gekennzeichnet**, daß in der Schlaufenkammer (3) Abstandshalter (4) vorgesehen sind, durch die die Seitenwände (1, 2) auf Drahtdurchmesser abgestimmten Abstand angeordnet sind.

3. Drahtabziehvorrichtung nach Anspruch 2, **dadurch gekennzeichnet**, daß an der Ausgangsseite der Schlaufenkammer (3) ein pneumatisch betätigter Klemmbacken (10) zum Klemmen des Drahtes (13) vorgesehen ist.

4. Drahtabziehvorrichtung nach Anspruch 1, **dadurch gekennzeichnet**, daß als Nachlaufbremse (12) eine pneumatisch betätigte Bremse vorgesehen ist.

# FIG 1

# FIG 2